# EUROPÄISCHE PATENTSCHRIFT

(11) **EP 1 349 270 B1**
(45) Veröffentlichungstag und Bekanntmachung des Hinweises auf die Patenterteilung: **19.10.2016**
(21) Anmeldenummer: 02007182.5
(22) Anmeldetag: 28.03.2002
(51) Int. Cl.: H03H 1/00

(54) **Elektrischer Filter und Kraftfahrzeug-Bordnetzversorgung mit einem solchen Filter**
Electrical filter and board circuit supply for motor vehicles with such a filter
Filtre électrique et alimentation de réseau de bord pour véhicules automobiles utilisant ledit filtre

(43) Veröffentlichungstag der Anmeldung: 01.10.2003
(73) Patentinhaber: TEMIC Automotive Electric Motors GmbH, 10553 Berlin (DE)
(72) Erfinder: Lindenberger, Heinz, D-86199 Augsburg (DE)
(74) Vertreter: Büchner, Jörg

(56) Entgegenhaltungen:
- EP-A- 0 216 389
- US-A- 5 105 332
- US-A- 6 037 846

## Beschreibung

Die Erfindung betrifft ein elektrisches Filter zur Dämpfung hochfrequenter Störanteile in Starkstrom, mit einem Durchführungsleiter, einem Ableitungsleiter und zwischen den Durchführungsleiter und den Ableitungsleiter geschalteten Kondensatoren, wobei der Durchführungsleiter um die Kondensatoren herumgeführt ist. Die Erfindung betrifft auch eine Kraftfahrzeug-Bordnetzversorgung mit einem solchen Filter.

Derartige Filter finden beispielsweise Verwendung in Gleichstromversorgungen, beispielsweise in Bordnetz-Stromversorgungen von Kraftfahrzeugen, Schienenfahrzeugen oder Flugzeugen. An derartige Bordnetze werden i.a. hohe Anforderungen hinsichtlich der elektromagnetischen Verträglichkeit (EMV) gestellt, und zwar derart, dass die Ausgangsspannung der Stromversorgung nur sehr kleine höherfrequente Störanteile aufweisen dürfen. Oft sind solche Filter zum Einbau in ein Abschirmungsgehäuse (z.B. des Gehäuses der Stromquelle) bestimmt, so dass sie gleichzeitig der Führung des Ausgangsleiters durch das Gehäuse dienen. Sie werden daher auch als Durchführungsfilter (Feed-Through-Filters) bezeichnet.

Filter der eingangs genannten Art sind beispielsweise in der Patentschrift US 6,037,846 A beschrieben. Filter mit nur einem Kondensator, sind beispielsweise aus den Patentschriften US 5,105,332 A, US 2,756,375 A und US 4,935,842 A bekannt.

Die bekannten Filter sind, besonders für große Ströme, hinsichtlich des benötigten Volumens und der erzielten Dämpfungswirkung noch nicht als optimal anzusehen.

Die Erfindung stellt ein elektrisches Filter zum Dämpfen hochfrequenter Störanteile in Starkstrom bereit. Das Filter weist einen Durchführungsleiter, einen Ableitungsleiter und zwischen den Durchführungsleiter und den Ableitungsleiter geschaltete Kondensatoren auf, wobei der Durchführungsleiter um die Kondensatoren herumgeführt ist und der Durchführungsleiter die nacheinander angeordneten Kondensatoren mäanderförmig umgibt.

Gemäß einem weiteren Aspekt stellt die Erfindung auch eine Kraftfahrzeug-Bordnetzversorgung mit einem solchen Filter zur Dämpfung von hochfrequenten Störspannungen, die von einer geschalteten Stromquelle der Kraftfahrzeug-Bordnetzversorgung herrühren, bereit.

Die Erfindung wird nun anhand von bevorzugten Ausführungsbeispielen unter Bezugnahme auf die angefügte beispielhafte Zeichnung näher erläutert. In der Zeichnung zeigen:
Fig. 1 eine Seitenansicht eines Filters;
Fig. 2 eine Draufsicht auf das Filter der Ausführungsform von
Fig. 1;

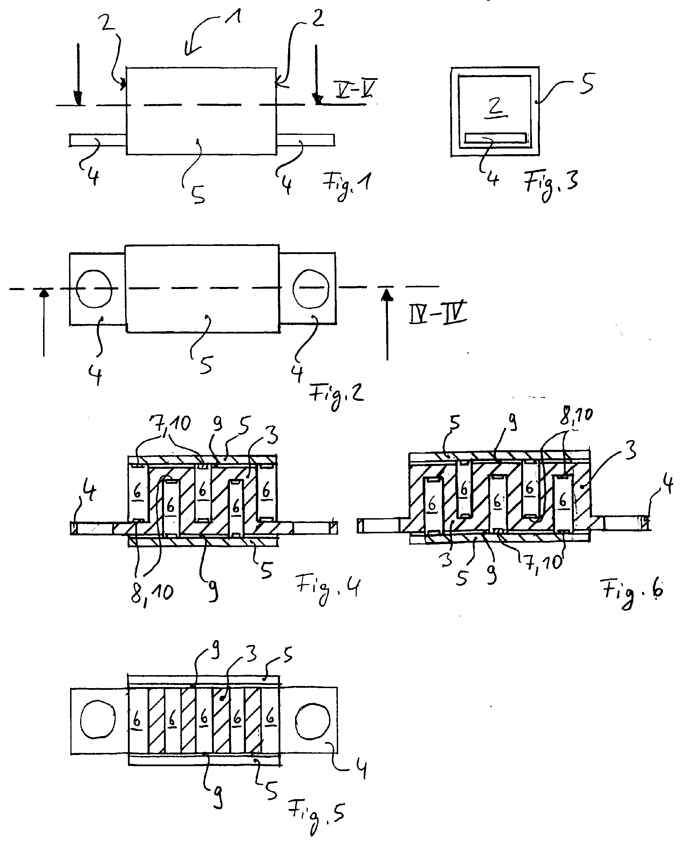

Fig. 3 eine Vorderansicht des Filters der Ausführungsform von
Fig. 1 und 2;
Fig. 4 eine Schnittansicht gemäß Linie IV-IV in Fig. 2;
Fig. 5 eine Schnittansicht gemäß Linie V-V in Fig. 1;
Fig. 6 eine Fig. 4 entsprechende Ansicht einer weiteren Ausführungsform mit vollständig mäanderförmig geführtem Leiter;

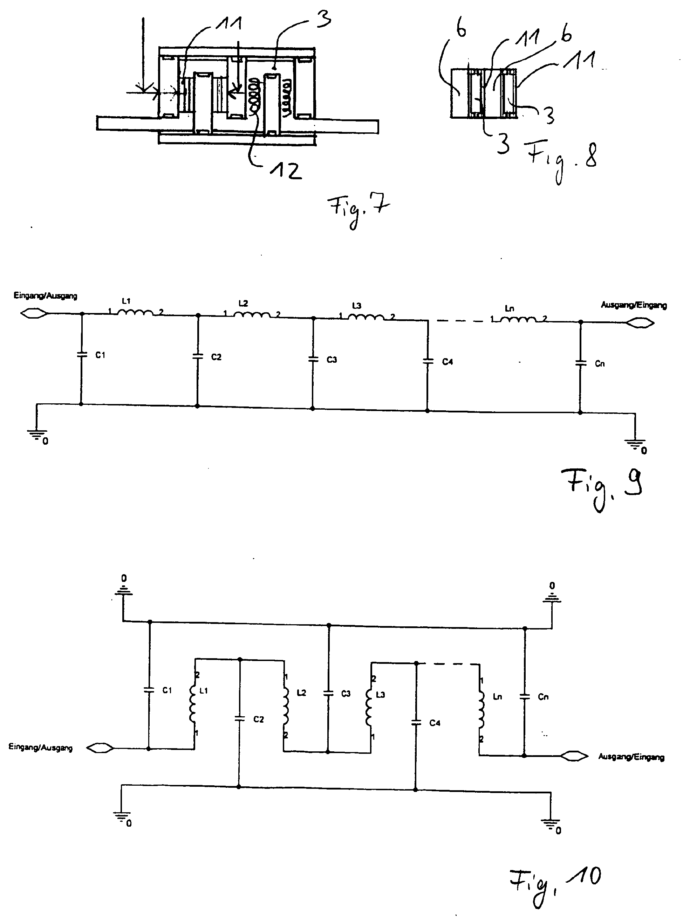

Fig. 7 eine Ansicht ähnlich Fig. 1 zur Veranschaulichung weiterer Ausführungsformen mit zusätzlichen Maßnahmen zur Induktivitätserhöhung;
Fig. 8 eine Schnittansicht eines Leiters mit magnetischem Kern von Fig. 7;
Fig. 9 ein Prinzipschaltbild einer n-stufigen Filterkette gemäß den Ausführungsbeispielen der Fig. 1 bis 8;
Fig. 10 ein Prinzipschaltbild entsprechend Fig. 9, jedoch in halbtopologischer Darstellung;

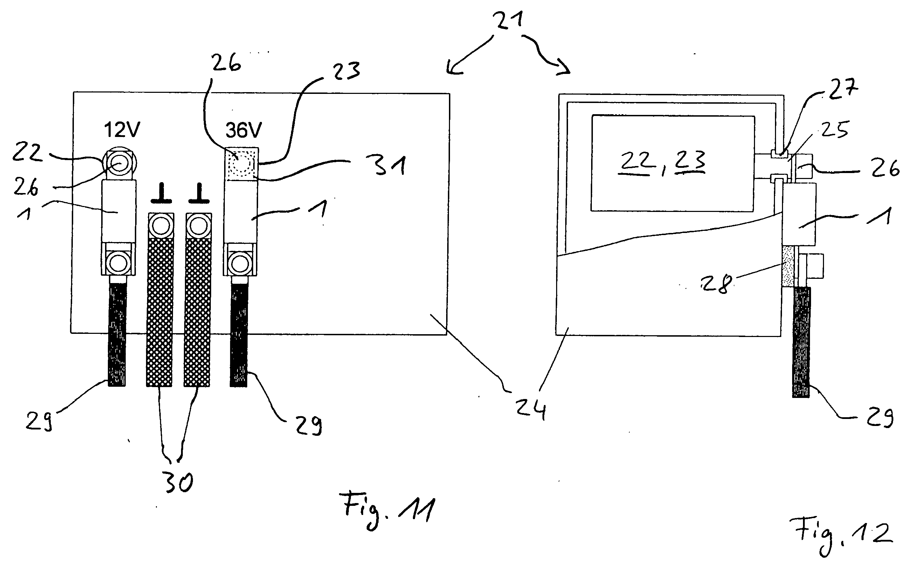

Fig. 11 veranschaulicht die Verwendung zweier Filter gemäß den Ausführungsformen der Fig. 1 bis 10 bei einer geschalteten Stromquelle für Kraftfahrzeugbordnetze in Vorderansicht;
Fig. 12 ist eine schematische Seitenansicht der Stromquelle mit den Filtern gemäß Fig. 11.

Fig. 1 zeigt eine Seitenansicht einer bevorzugten Ausführungsform eines Filters zum Dämpfen hochfrequenter Störanteile in Starkstrom. Vor einer detaillierten Erläuterung der Fig. 1 folgen zunächst einige allgemeinere Anmerkungen zu den bevorzugten Ausführungsformen.

Die Filter der in den Figuren dargestellten Ausführungsformen weisen jeweils fünf Kondensatoren auf, sind also fünfstufige Filter. Dies ist nur beispielhaft, möglich sind - je nach gewünschter Filterwirkung - auch weniger (z.B. zwei) oder mehr (z.B. acht) Kondensatoren (man erhält dann beispielsweise zweistufige bzw. achtstufige Filter).

Bei den in den Fig. 1 bis 5 und 7 dargestellten Ausführungsformen ist der Durchführungsleiter teils L-förmig und teils U-förmig um Kondensatoren (also teils um zwei Seiten und teils um drei Seiten eines Kondensators) herumgeführt. Das in Anspruch 1 genannte Merkmal, daß der Durchführungsleiter um den Kondensator herumgeführt ist, soll sich also bereits auf eine zweiseitige Herumführung, insbesondere jedoch auf eine (besonders vorteilhafte) dreiseitige Herumführung beziehen. Bei der in Fig. 6 dargestellten, besonders bevorzugten Ausführungsform ist der Durchführungsleiter um alle Kondensatoren U-förmig herumgeführt.

Bei den bevorzugten Ausführungsformen umgibt der Ableitungsleiter den Durchführungsleiter. Bei einem solchen Aufbau kann der - zur Erzielung der Filterfunktion in der Regel auf Masse zu legende - Ableitungsleiter zugleich als Abschirmung des Filters fungieren. Dies erlaubt den Einsatz des Filters als sog. Durchführungsfilter, also als Filter, welches an der Durchführung eines Leiters durch ein abschirmendes Gehäuse angeordnet werden kann. Der Ableitungsleiter kann dabei direkt auf das (mit Masse verbundenen) abschirmende Gehäuse aufgesetzt und so mit diesem kontaktiert sein.

Bei den gezeigten Ausführungsformen weist der Kondensator zwei sich gegenüberliegende Anschlußseiten und, im übrigen, isolierende Seiten auf. Bei der U-förmigen Herumführung ist der Durchführungsleiter an einer isolierenden Seite, einer Anschlußseite und einer weiteren isolierenden Seite um den Kondensator herumgeführt. Dabei ist der Durchführungsleiter mit der genannten Anschlußseite des Kondensators elektrisch verbunden; die zweite Anschlußseite des Kondensators ist hingegen mit dem Ableitungsleiter elektrisch verbunden. Der Durchführungsleiter ist aufgrund der Herumführung im Vergleich zu den im Stand der Technik bekannten Filtern verlängert und weist daher eine relativ große Induktivität auf. Zusammen mit dem zum Ableitungsleiter geschalteten Kondensator bildet er einen Tiefpaßfilter, der Gleichspannung und Spannungen mit einer Frequenz unterhalb einer Grenzfrequenz nahezu ungedämpft durchläßt, während er Spannungen oberhalb der Grenzfrequenz dämpft.

Bei den bevorzugten Ausführungsformen bildet der Durchführungsleiter bei der U-förmigen Herumführung eine Tasche, in der der Kondensator gehaltert ist. Die U-förmige Herumführung hat also neben der genannten elektrischen Funktion einer Induktivitätserhöhung eine mechanische Halterungsfunktion.

Bei der in den Figuren dargestellten Ausführungsform sind an den beiden Anschlußstellen des Kondensators, und zwar einerseits an der Kontaktstelle zum Durchführungsleiter und andererseits an derjenigen zum Ableitungsleiter Kontaktfedern angeordnet. Diese ergeben nach dem Zusammenbau des Filters automatisch eine sichere und auch dauerhafte Kontaktierung des Kondensators und erbringen bei den gezeigten Ausführungsformen mit äußeren Ableitungsleiter eine Selbstfixierung des Durchführungsleiters im Ableitungsleiter.

Eine gegenüber einem Einzelfilter erhöhte Dämpfungswirkung wird durch die Ausbildung mit mehreren Kondensatoren, also als mehrstufiges Filter erzielt. Dabei sind längs dem Durchführungsleiter mehrere Kondensatoren zum Ableitungsleiter geschaltet. Der Durchführungsleiter umgibt die mehreren Kondensatoren mäanderartig. Bei den bevorzugten Ausführungsform sind die aufeinanderfolgenden Kondensatoren so angeordnet, daß die mit dem Durchführungsleiter kontaktierten Anschlußseiten und die mit dem Ableitungsleiter kontaktierten Anschlußseiten der Kondensatoren alternierend aufeinander folgen.

Bei den bevorzugten Ausführungsformen wirken die Kondensatoren als Schirmwände zwischen den einzelnen Stufen des Filters und reduzieren dadurch die Überkopplung zwischen den Stufen, so daß eine hohe Dämpfungswirkung auch bis zu sehr hohen Frequenzen (z.B. bis in den GHz-Bereich) erhalten bleibt. Für die Wirkung als Schirmwand werden vorzugsweise Kondensatoren verwendet, bei denen wenigstens eine mit dem Ableitungsleiter verbundene Kondensatorelektrode sich im wesentlichen von der einen zur anderen Anschlußseite des Kondensators erstreckt. Die L- oder U-förmige Herumführung wirkt sich auf die Filterwirkung nicht nur wegen der damit einhergehendenden Induktivitätserhöhung positiv aus, sondern auch wegen der Dämpfung hochfrequenter Überkoppelungen zwischen den Filterstufen.

Bei weiteren Ausführungsformen kann der Durchführungsleiter zwischen den Kondensatoren zur weiteren Erhöhung der Induktivität (und damit Verschiebung der unteren Grenzfrequenz zu niedrigeren Frequenzen) mit magnetischen Kernen (z.B. aus Eisenpulver) ausgerüstet sein, oder es kann dort die Durchführungsleitung zumindest teilweise gewendelt ausgeführt sein.

Das Filter gemäß den bevorzugten Ausführungsformen ist ein Starkstromfilter, welches für Ströme im Bereich von 100 A bis 1000 A und darüber ausgelegt ist. Es handelt sich also nicht etwa um ein nachrichtentechnisches Filter, sondern vielmehr um ein solches, das beispielsweise für den Einsatz in Stromversorgungen von Kraftfahrzeugen, Schienenfahrzeugen, Flugzeugen, Telekommunikationseinrichtungen, militärischen Geräten etc. geeignet ist.

Die Spannungen, für die das Filter ausgelegt ist, liegen i.a. im Niederspannungsbereich, der typischerweise bis 60 V reicht. Grundsätzlich kann ein Filter der beschriebenen Art auch für höhere Spannungen Verwendung finden, wobei dann Kondensatoren mit besonders geringen Leckströmen zu verwenden sind, um zu gewährleisten, daß die Ableitströme trotz der hohen Spannungen ausreichend klein bleiben.

Vorzugsweise handelt es sich bei der Hauptkomponente der zu filternden Spannung um Gleichspannung. Möglich sind jedoch auch Wechselspannungen unterhalb der Grenzfrequenz. Bei Wechselspannungsbetrieb eines derartigen Starkstromfilters sind allerdings relativ hohe Blindströme durch die Filterkondensatoren in Kauf zu nehmen.

Bei einer bevorzugten und im folgenden näher beschriebenen Anwendung ist das Filter zwischen eine geschaltete Stromquelle für ein Kraftfahrzeug-Bordnetz und das Bordnetz geschaltet. Die Stromquelle hat beispielsweise eine Leistung von 10 kW und eine Spannung von 12 V. Durch das Filter fließen somit Ströme von über 800 A. Die Taktfrequenz der geschalteten Stromquelle beträgt beispielsweise 100 kHz, so daß es in der Gleichspannung hochfrequente Spannungsanteile von der Taktfrequenz (z.B. 100 kHz) und ihren Oberwellen gibt. Augrund von Mischeffekten in nicht-linearen Bauteilen entstehen häufig sehr signifikante Störanteile bis über 100 MHz. Durch Hintereinanderschaltung einer ausreichend großen Anzahl von Filterstufen lassen sich bei Verwendung einer solchen getakteten Stromquelle des Filters die für Kraftfahrzeug-Bordnetze geltenden strengen EMV-Bestimmungen erfüllen, welche nur sehr kleine Störspannungen hoher Frequenz zulassen. Durch die mäanderförmige Führung des Durchführungsleiters ist das Filter relativ kompakt aufgebaut, und damit insbesondere für den Einsatz im Fahrzeugen.

Nun zurückkehrend zu den Fig. 1 bis 5, ist dort eine bevorzugte Ausführungsform eines Filters gezeigt, und zwar in Fig. 1 in Seitenansicht, in Fig. 2 in Draufsicht, in Fig. 3 in Vorderansicht und in Fig. 4 und 5 in Schnittansichten.

Das Filter 1 weist einen Durchführungsleiter 3 und einen Ableitungsleiter 5 auf. Es hat die Form eines länglichen Quaders, der in Längsrichtung gesehen, einen nahezu quadratischen Querschnitt hat. An den beiden gegenüberliegenden Stirnseiten 2 des Quaders ragt jeweils der Durchführungsleiter 3 in Form einer, mit einer Anschlußbohrung versehenen Anschlußlasche 4 heraus. Die äußere Wandung des Quaders - ohne die Stirnseiten 2 - bildet den Ableitungsleiter 5, der im eingebauten Zustand des Filters 1 i.a. mit der Masse verbunden ist (bei einem Mehrphasensystem kann er auch mit einer anderen Phase als derjenigen des Durchführungsleiters 3 verbunden sein).

Wie die Querschnittansichten gemäß Fig. 4 und 5 zeigen, weist das beispielhaft dargestellte Filter 1 fünf Filterkondensatoren 6 auf, die zwischen Durchführungsleiter 3 und Ableitungsleiter 5 geschaltet sind. Jeweils zwischen den Anschlußpunkten liegende Abschnitte der Kondensatoren 6 stellen Induktivitäten dar. Jede Gruppe von Induktivität und Kondensator 6 bildet eine Filterstufe, wobei die einzelnen Filterstufen in Reihe geschaltet sind. Es handelt sich somit um ein fünfstufiges Filter, entsprechend dem Schaltplan von Fig. 7.

Die Filterkondensatoren 6 haben die Form flacher Quader, deren zwei gegenüberliegende Schmalseiten Anschlußseiten 7, 8 für die im Inneren der Kondensatoren 6 befindlichen Kondensatorelektroden bilden, und deren andere beiden Schmalseiten sowie deren beiden Flachseiten elektrisch isolierend sind. Bei den Filterkondensatoren 6 handelt es sich vorzugsweise um Folienkondensatoren, bei denen die Kondensatorelektroden wenigstens teilweise parallel zu den Flachseiten des Kondensators angeordnet ist, so daß die Kondensatoren 6 die bereits oben angesprochene Abschirmwirkung zwischen den Filterstufen haben. Die Filterkondensatoren 6 sind mit ihren Flachseiten senkrecht zur Längsrichtung des Filters 1 angeordnet, und zwar so, daß die Anschlußseiten 7 zum Ableitungsleiter 5 von Stufe zu Stufe alternierend oben und unten am Ableitungsleiter 5 liegen (als "unten" wird hier diejenige Seite des Filters bezeichnet, an der die Anschlußlaschen 4 herausgeführt sind; "oben" bezeichnet die gegenüberliegende Seite).

Der Durchführungsleiter 3 hat die Querschnittsform eines flachen Rechtecks und ist vorzugsweise aus Kupfer gefertigt. Er ist im Inneren des Ableitungsleiters 5 mäanderförmig um die quergestellten Filterkondensatoren 6 herumgeführt. Da bei der gezeigten Ausführungsform gemäß Fig. 1 bis 5 die Anschlußlaschen 4 im unteren Teil aus dem Filter 1 herausgeführt sind, die am Eingang und Ausgang des Filters 1 liegenden Filterkondensatoren 6 jedoch oben am Ableitungsleiter 5 kontaktiert sind, ist der Durchführungsleiter 3 jeweils nur um zwei Seiten, also L-förmig um den ersten und letzten Filterkondensator 6 herumgeführt. Hingegen umgibt er die drei innenliegenden Filterkondensatoren 6 in Form eines "U" jeweils an drei Seiten (siehe Fig. 4).

Bei einer besonders bevorzugten, in Fig. 6 gezeigten Ausführungsform sind sämtliche Filterkondensatoren U-förmig vom Durchführungsleiter umgeben, indem die jeweils außenliegenden Filterkondensatoren an derjenigen Seite des Ableitungsleiters kontaktiert sind, an der auch die Anschlußlaschen angeordnet sind. Abgesehen hiervon gelten für die Ausführungsform der Fig. 6 sämtliche obigen und noch folgenden Ausführungen.

Nun zurückkehrend zu Fig. 4, sind die Kondensatoren 6 mit ihren den Anschlußseiten 7 gegenüberliegenden Anschlußseiten 8 mit dem Durchführungsleiter 3 kontaktiert, und zwar jeweils an der in Filterlängsrichtung verlaufenden Basis des U-förmigen Abschnitts des Durchführungsleiters (bzw. an dem in Filterlängsrichtung verlaufenden Schenkel des L-förmigen Durchführungsleiterabschnitts).

Der Durchführungsleiter 3 ist gegen den Ableitungsleiter 5 elektrisch isoliert, und zwar durch seitlich sowie oben und unten sich in Filterlängsrichtung erstreckende Isolatoreinsätze 9.

Zwischen den Anschlußseiten 7, 8 der Filterkondensatoren 6 und dem Ableitungsleiter 5 bzw. Durchführungsleiter 3 sind jeweils leitfähige elastische Kontaktelemente, hier Kontaktfedern 10 angeordnet. Diese ergeben nach dem Zusammenbau automatisch eine sichere und dauerhafte Kontaktierung der Filterkondensatoren und bringen durch die von ihnen ausgeübten Querkräfte auch eine Selbstfixierung des Durchführungsleiters 3 im Ableitungsleiter 5. Statt Kontaktfedern können beispielsweise Kontaktstücke aus leitfähigem Elastomer verwendet werden.

Bei den gezeigten Ausführungsformen hat der Ableitungsleiter 5 die Form eines Rohres mit quadratischem Querschnitt. Die Breite des Durchführungsleiters 3 und der Filterkondensatoren 6, zuzüglich der seitlichen Isolatoreinsätze 9, entspricht der inneren freien Breite des Ableitungsleiters 5. In der dazu senkrechten Richtung quer zur Filterachse entspricht die Summe der Höhe des Durchführungsleiters 3 und der Filterkondensatoren 6, zuzüglich der für einen oberen bzw. unteren Isolatoreinsatz 9 und für zwei komprimierte Kontaktfedern 10 benötigte Höhe der inneren freien Höhe des Ableitungsleiters 5.

Die bei den Ausführungsformen gezeigte U-förmige Umfassung der Filterkondensatoren 6 durch den Durchführungsleiter 3 hat verschiedene Vorteile. In mechanischer Hinsicht stellt sie eine Halterung der Kondensatoren 6 in einer Art Tasche dar. In elektrischer Hinsicht wirken die quergestellten Filterkondensatoren 6 als Schirmwände zwischen den einzelnen Filterstufen, was Überkopplungen von Störungen von einer Filterstufe zur nächsten vermindert. Eine derartige Schirmwandwirkung wird dann erzielt, wenn die mit dem Ableitungsleiter 5 kontaktierte Kondensatorelektrode (im Inneren der Filterkondensatoren 6) sich wenigstens teilweise parallel zur Kondensatorflachseite (d.h. quer zur Filterlängsrichtung) erstreckt, was bei üblichen Kondensatoren zur Erzielung relativ hoher Kapazitätswerte der Fall ist. Ein weiterer Vorteil der mäanderförmigen Herumführung des Durchführungsleiters 3 um die Filterkondensatoren 6 liegt darin, daß - bei insgesamt kompaktem Aufbau des Filters 1 - die Länge der Abschnitte des Durchführungsleiters 3 von einem Anschlußpunkt 8 zum nächsten relativ groß gegenüber der effektiven Länge der Filterkondensatoren 6 ist, welche derjenigen Länge entspricht, die die Ableitungs-Blindströme in den Filterkondensatoren 6 im Mittel durchlaufen. Ein Problem bei sehr hohen Störspannungsfrequenzen (d.h. Frequenzen im GHz-Bereich) liegt nämlich darin, daß Filterkondensatoren dort eine sog. parasitäre Induktivität zeigen. Die für die Filterung wirksame Spannungsteilung pro Stufe entspricht dann näherungsweise dem Verhältnis zwischen der Zuleitungsinduktivität und der parasitären Kondensatorinduktivität. Die durch die vorliegende Anordnung realisierte relativ hohe Zuleitungsinduktivität (aufgrund der großen Länge der Durchführungsleiterabschnitte zwischen den Kondensatoranschlußpunkten relativ zur effizienten Länge der Filterkondensatoren) stellt somit auch bei sehr hohen Filterfrequenzen eine noch ausreichende Filterwirkung sicher.

Ein ausgeführtes Beispiel eines Filters nach Art des in den Fig. 1 bis 5 gezeigten Filters ist für eine Spannung von 60 V und einen Dauerstrom von 600 A Gleichstrom ausgelegt. Die Gehäuseabmessungen des Filters (d.h. die Außenabmessungen des Ableitungsleiters) betragen 50 mm x 24 mm x 24 mm. Die Breite des Durchführungsleiters beträgt 20 mm. Das Filter ist sechsstufig, es ist mit sechs Folienkondensatoren à 4,7 *µ*F ausgerüstet. Damit wurde eine Dämpfung größer 100 dB im Bereich 3 MHz bis 500 MHz und größer 80 dB im Bereich von 2 MHz bis 1,1 GHz erzielt.

Fig. 7 veranschaulicht weitere Ausführungsformen, bei denen die Durchführungsleiterabschnitten zwischen den Filterkondensatoren 6 mit magnetische Kernen 11, z.B. aus Eisenpulver ausgerüstet sind. Der Begriff "Kern" ist hier im übertragenen Sinn zu verstehen, da die Kerne 11 vorzugsweise gemäß Fig. 8 die Form von den Durchführungsleiter 3 ringförmig umschließenden Schalen haben. Diese sind vorteilhaft in Längsrichtung geteilt ausgeführt, damit sie bei der Montage des Filters einfach auf den Durchführungsleiter 3 aufgesteckt werden können. Alternativ können die genannten Durchführungsleiterabschnitte auch gewendelt ausgeführt sein, was in Fig. 7 bei Bezugszeichen 12 veranschaulicht ist. Beide Maßnahmen bewirken eine weitere Erhöhung der Induktivität der Durchführungsleiterabschnitte und damit eine Verschiebung der unteren Eckfrequenz zu niedrigeren Frequenzen.

Fig. 9 zeigt ein Prinzipschaltbild einer n-stufigen Filterkette gemäß der Ausführungsformen der Fig. 1 bis 8. Die durchgehende Leitung mit den in Reihe geschalteten Induktivitäten L1, L2, L3,....Ln entspricht dabei dem Durchführungsleiter 3, die hier diskret dargestellten Induktivitäten L1, L2, L3...Ln symbolisieren die Induktivitäten der zwischen den Anschlußpunkten der Filterkondensatoren 6 liegenden Abschnitte des Durchführungsleiters 3. Die in Fig. 7 mit Masse verbundene Leitung entspricht dem Ableitungsleiter 5. Die jeweils zwischen den Induktivitäten die eine mit der anderen Leitung verbindenden Kapazitäten C1, C2, C3, C4....Cn entsprechen den Filterkondensatoren 6.

Fig. 9 zeigt eine sog. halbtopologische Darstellung des Prinzipschaltbilds von Fig. 7, also eine Darstellung, welche die räumliche Anordnung der verschiedenen Filterelemente berücksichtigt. Zu diesem Zweck ist die mit Masse verbundene Leitung hier in Form von zwei Leitungen dargestellt, welche die den Eingang und den Ausgang verbindende Leitung und die Filterelemente zwischen sich aufnehmen. Diese beiden, mit Masse verbundenen Leitungen entsprechen der oberen und unteren Seite des Ableitungsleiters 5 in Fig. 4 und 6. Entsprechend sind in Fig. 9 ein Teil der Kapazitäten (C1, C3, Cn) mit der oberen Masseleitung, ein anderer Teil (C2, C4) mit der unteren Masseleitung verbunden. Die Eingang und Ausgang verbindende Leitung ist mäanderförmig dargestellt, entsprechend der mäanderförmigen Führung des Durchführungsleiters 3 in Fig. 4 und 6.

Die Fig. 11 und 12 veranschaulichen eine Verwendung von Filtern gemäß Fig. 1 bis 10 bei einer Bordnetzversorgung 21 für ein Kraftfahrzeug. Die Bordnetzversorgung 21 umfaßt zwei Gleichstromquellen 22,23 eine für 12 V, die andere für 36 V, zur Speisung eines 12 V- bzw. eines 36 V-Kraftfahrzeugbordnetzes. Das 36 V-Bordnetz dient hauptsächlich der Versorgung von Hochleistungsverbrauchern, wie elektrischen Heizungen, elektrischen Ventiltrieben, elektrischen Bremssystemen und elektrischen Lenksystemen. Das 12 V-Bordnetz dient hauptsächlich der Speisung solcher Verbraucher, die vorzugsweise nur mit niedriger Spannung zu betreiben sind, wie Glühlampen. Zur Erzeugung der beiden Spannungen, beispielsweise aus einer höheren, vom Kraftfahrzeuggenerator gelieferten Spannung sind die Stromquellen als Wandler, bei denen es sich beispielsweise um Gleichspannungs-Gleichspannungs-Wandler oder Wechselspannungs-Gleichspannungswandler handeln kann (je nachdem, ob die gelieferte Spannung Gleich- oder Wechselspannung ist). Die Bordnetzversorgung 21 weist ein Metallgehäuse 24 auf, mit je einer 12 V- bzw. 36 V-Leiterdurchführung 25, die in einem 12 V- bzw. 36 Volt-Anschlußpunkt 26 endet. Die Leiterdurchführungen 25 sind gegenüber dem Metallgehäuse 24 mit Isolierungen 27 ausgerüstet. An den Anschlußpunkten 26 ist jeweils ein Filter 1 der in den Fig. 1 bis 8 gezeigten Art mit einer der beiden Anschlußlaschen 4 angeschlossen. Die jeweils andere Anschlußlasche 4 ruht auf einer Isolierstütze 28, welche neben einer mechanischen Abstützung der Anschlußlasche 4 für deren Isolierung gegenüber dem Metallgehäuse 24 sorgt. Die Gehäuse der Filter 1 (d.h. deren Ableitungsleiter 5) sind mit dem Metallgehäuse 24 kontaktiert, welches wiederum elektrisch mit Masse verbunden ist. Die auf den Isolierstützen 28 liegenden Anschlußlaschen 4 sind jeweils mit einem Stromkabel 29 verbunden, welches zum 12 V-bzw. 36 V-Bordnetz führt. Für die Rückleitung aus diesen Bordnetzen sorgen Massekabel 30, welche mit den Gleichstromquellen 22 verbunden sind.

Die Gleichstromquellen 22, 23 sind geschaltete Stromquellen, d.h. die Wandler erzeugen die gewünschte Gleichspannung durch Pulsmodulation mit Hilfe von elektronischen Schaltern. Typische Taktfrequenzen hierfür liegen im Bereich von 10 kHZ bis 100 kHz. Den am Ausgang der Wandler anliegenden Gleichspannungen sind daher Störspannungen mit Frequenzen überlagert, die von der Taktfrequenz bis in den GHz-Bereich reichen. Die zwischen die Wandler und die Bordnetze geschalteten Filter 1 dämpfen diese Störungen so stark, daß sie nurmehr in einem, den EMV-Bestimmungen genügenden Ausmaß in die Bordnetze gelangen.

Um die Abstrahlung von Störfrequenzen zu vermeiden, können die zwischen Wandler und Filter 1 außerhalb des Metallgehäuses 24 liegenden Leiterteile mit je einer Schirmkappe 31 abgedeckt sein. Alternativ ist es (bei nicht gezeigten Ausführungsformen) möglich, das Filter ganz oder teilweise in das Metallgehäuse zu verlegen, so daß sich nur der zum Bordnetz führende Anschlußpunkt des Filters außen am Gehäuse befindet.

Die beschriebenen bevorzugten Ausführungsformen stellen also ein Durchlaßfilter für große Ströme bereit, welches bei einem sehr kompakten Aufbau hohe Dämpfungswerte, auch bei hohen Frequenzen, aufweist.

## Patentansprüche

1. Elektrisches Filter zur Dämpfung hochfrequenter Störanteile in Starkstrom, mit einem Durchführungsleiter (3), einem Ableitungsleiter (5) und zwischen den Durchführungsleiter (3) und den Ableitungsleiter (5) geschalteten Kondensatoren (6), wobei der Durchführungsleiter (3) um die Kondensatoren (6) herumgeführt ist, **dadurch gekennzeichnet, dass** der Durchführungsleiter (3) die nacheinander angeordneten Kondensatoren (6) mäanderartig umgibt.

2. Elektrisches Filter nach Anspruch 1, bei welchem der Ableitungsleiter (5) den Durchführungsleiter (3) umgibt.

3. Elektrisches Filter nach Anspruch 1 oder 2, bei welchem der Kondensator (6) zwei Anschlussseiten (7, 8) und, im Übrigen, isolierende Seiten aufweist, und bei welchem der Durchführungsleiter (3) an drei Seiten des Kondensators (6) um diesen geführt ist, und zwar an einer isolierenden Seite, einer ersten Anschlussseite und einer weiteren isolierenden Seite, wobei der Durchführungsleiter (3) mit der ersten Anschlussseite (8) elektrisch verbunden ist, und die zweite Anschlussseite (7) des Kondensators (6) mit dem Ableitungsleiter (5) elektrisch verbunden ist.

4. Elektrisches Filter nach einem der Ansprüche 1 bis 3, bei welchem der um den Kondensator (6) geführte Durchführungsleiter (3) eine Tasche bildet, in der der Kondensator (6) gehaltert ist.

5. Elektrisches Filter nach einem der Ansprüche 1 bis 4, bei welchem zwischen Durchführungsleiter (3) und einer zum Durchführungsleiter (3) gewandten Anschlussseite (8) des Kondensators (6) und/oder zwischen der anderen Anschlussseite (7) des Kondensators (6) und dem Ableitungsleiter (5) eine Kontaktfeder (10) angeordnet ist.

6. Elektrisches Filter nach einem der Ansprüche 1 bis 5, bei welchem bei den nacheinander angeordneten Kondensatoren (6) die mit dem Durchführungsleiter (3) kontaktierten Anschlussseiten (8) und die mit dem Ableitungsleiter (5) kontaktierten Anschlussseiten (7) der Kondensatoren (6) alternierend aufeinanderfolgen.

7. Elektrisches Filter nach einem der Ansprüche 1 bis 6, bei welchem die Kondensatoren (6) als Schirmwände zwischen den einzelnen Stufen des Filters (1) wirken und dadurch eine Überkopplung zwischen den Stufen reduzieren.

8. Elektrisches Filter nach einem der Ansprüche 1 bis 7, bei welchem zur Erhöhung der Induktivität magnetische Kerne (11) an dem Durchführungsleiter zwischen den Kondensatoren (6) vorgesehen sind oder der Durchführungsleiter (3) zumindest teilweise gewandelt geführt ist.

9. Elektrisches Filter nach einem der Ansprüche 1 bis 8, welches für einen Strom ausgelegt ist, der im Bereich von 100 A bis 1000 A oder darüber liegt.

10. Elektrisches Filter nach einem der Ansprüche 1 bis 9, welches für den Niederspannungsbereich ausgelegt ist.

11. Kraftfahrzeug-Bordnetzversorgung mit einem elektrischen Filter (1) nach einem der Ansprüche 1 bis 10, zur Dämpfung von hochfrequenten Störspannungen, die von einer geschalteten Stromquelle (22, 23) der Kraftfahrzeug-Bordnetzversorgung (21) herrühren.

## Claims

1. Electrical filter for attenuating high-frequency interference components in high-power applications, comprising a bushing conductor (3), a discharge conductor (5) and capacitors (6) which are connected between the bushing conductor (3) and the discharge conductor (5), wherein the bushing conductor (3) is routed around the capacitors (6), **characterized in that** the bushing conductor (3) surrounds the capacitors (6), which are arranged in succession, in a meandering manner.

2. Electrical filter according to Claim 1, in which the discharge conductor (5) surrounds the bushing conductor (3).

3. Electrical filter according to Claim 1 or 2, in which the capacitor (6) has two connection sides (7, 8) and, moreover, insulating sides, and in which the bushing conductor (3) is routed around the capacitor on three sides of the said capacitor (6), specifically on an insulating side, a first connection side and a further insulating side, wherein the bushing conductor (3) is electrically connected to the first connection side (8), and the second connection side (7) of the capacitor (6) is electrically connected to the discharge conductor (5).

4. Electrical filter according to one of Claims 1 to 3, in which the bushing conductor (3) which is routed around the capacitor (6) forms a pocket in which the capacitor (6) is held.

5. Electrical filter according to one of Claims 1 to 4, in which a contact spring (10) is arranged between the bushing conductor (3) and a connection side (8) of the capacitor (6), which connection side faces the bushing conductor (3), and/or between the other connection side (7) of the capacitor (6) and the discharge conductor (5).

6. Electrical filter according to one of Claims 1 to 5, in which, in the capacitors (6) which are arranged in succession, the connection sides (8), with which the bushing conductor (3) makes contact, and the connection sides (7) of the capacitors (6), with which connection sides the discharge conductor (5) makes contact, alternate with one another.

7. Electrical filter according to one of Claims 1 to 6, in which the capacitors (6) act as shielding walls between the individual stages of the filter (1) and in this way reduce cross-coupling between the stages.

8. Electrical filter according to one of Claims 1 to 7, in which, in order to increase the inductance, magnetic cores (11) are provided on the bushing conductor between the capacitors (6) or the bushing conductor (3) is routed in an at least partially helical manner.

9. Electrical filter according to one of Claims 1 to 8, which is designed for a current which lies in the range of from 100 A to 1000 A or above.

10. Electrical filter according to one of Claims 1 to 9, which is designed for the low-voltage range.

11. On-board motor vehicle supply system comprising an electrical filter (1) according to one of Claims 1 to 10 for attenuating high-frequency interference voltages which originate from a connected power source (22, 23) of the on-board motor vehicle supply system (21).

## Revendications

1. Filtre électrique d'atténuation des parasites à haute fréquence de courants forts, présentant un conducteur de passage (3), un conducteur d'évacuation (5) et des condensateurs (6) raccordés entre le conducteur de passage (3) et le conducteur d'évacuation (5), le conducteur de passage (3) entourant les condensateurs (6), **caractérisé en ce que** le conducteur de passage (3) entoure en méandres les condensateurs (6) disposés les uns derrière les autres.

2. Filtre électrique selon la revendication 1, dans lequel le conducteur d'évacuation (5) entoure le conducteur de passage (3).

3. Filtre électrique selon les revendications 1 ou 2, dans lequel le condensateur (6) présente deux côtés de raccordement (7, 8) et pour le reste des côtés isolants, et dans lequel le conducteur de passage (3) est placé autour de trois côtés du condensateur (6), à savoir un côté isolant, un premier côté de raccordement et un deuxième côté isolant, le conducteur de passage (3) étant raccordé électriquement au premier côté de raccordement (8) et le deuxième côté de raccordement (7) du condensateur (6) étant raccordé électriquement au conducteur d'évacuation (5).

4. Filtre électrique selon l'une des revendications 1 à 3, dans lequel le conducteur de passage (3) placé autour du condensateur (6) forme une poche dans laquelle le condensateur (6) est maintenu.

5. Filtre électrique selon l'une des revendications 1 à 4, dans lequel un ressort de contact (10) est disposé entre le conducteur de passage (3) et un côté de raccordement (8), tourné vers le conducteur de passage (3), du condensateur (6) et/ou entre l'autre côté de raccordement (7) du condensateur (6) et le conducteur d'évacuation (5).

6. Filtre électrique selon l'une des revendications 1 à 5, dans lequel les côtés de raccordement (8) en contact avec le conducteur de passage (3) et les côtés de raccordement (7), en contact avec le conducteur d'évacuation (5), des condensateurs (6) se suivent en alternance lorsque les condensateurs (6) sont disposés les uns derrière les autres.

7. Filtre électrique selon l'une des revendications 1 à 6, dans lequel les condensateurs (6) agissent comme parois de blindage entre les différents étages du filtre (1) et réduisent ainsi le surcouplage entre les étages.

8. Filtre électrique selon l'une des revendications 1 à 7, dans lequel, pour augmenter l'inductance, des noyaux magnétiques (11) sont prévus sur le conducteur de passage entre les condensateurs (6) ou au moins certaines parties du conducteur de passage (3) sont guidées de manière modifiée.

9. Filtre électrique selon l'une des revendications 1 à 8, conçu pour un courant de l'ordre de 100 A à 1 000 A ou plus.

10. Filtre électrique selon l'une des revendications 1 à 9, conçu pour la plage des basses tensions.

11. Alimentation de réseau de bord de véhicules automobiles présentant un filtre électrique (1) selon l'une des revendications 1 à 10 pour l'atténuation des parasites à haute fréquence provoqués par le branchement d'une source (22, 23) de courant de l'alimentation (21) du réseau de bord du véhicule automobile.
